# EUROPEAN PATENT SPECIFICATION

(11) **EP 3 174 095 B1**
(45) Date of publication and mention of the grant of the patent: **04.12.2019**
(21) Application number: 16200117.6
(22) Date of filing: 22.11.2016
(51) Int. Cl.: H01L 25/075, H01L 27/15

(54) **LIGHT EMITTING APPARATUS**
LICHTEMITTIERENDE VORRICHTUNG
APPAREIL ÉLECTROLUMINESCENT

(30) Priority: 24.11.2015 JP 2015229112
(43) Date of publication of application: 31.05.2017
(73) Proprietor: Stanley Electric Co., Ltd., Meguro-ku Tokyo 153 (JP)
(72) Inventor: KAWAI, Ryosuke, Tokyo, 153-8636 (JP); MIYACHI, Mamoru, Tokyo, 153-8636 (JP); YAMANE, Takayoshi, Tokyo, 153-8636 (JP)
(74) Representative: Carstens, Dirk Wilhelm

(56) References cited:
- EP-A2- 2 341 536
- WO-A1-2012/059837
- WO-A1-2015/091005
- US-A1- 2011 026 266
- US-A1- 2015 325 598

## Description

### BACKGROUND OF THE INVENTION

### 1. Field of the Invention

The present invention relates to a light emitting apparatus and, in particular, to a light emitting apparatus using a light emitting diode (LED).

### 2. Background Art

A light emitting apparatus mounted with a plurality of light emitting devices has conventionally been used in, for example, a lighting device, back light, and an industrial device. JP 2009-267423 A and JP 2009-296012 A disclose a light emitting device in which a plurality of light emitting diode devices is mounted in a matrix form on one mounting substrate which is an insulating substrate.

EP 2 341 536 A1 discloses a lighting apparatus which includes a conductive main body at a ground potential, a light-emitting device in the main body, and a lighting control device configured to supply power to the light-emitting device. The light-emitting device includes a substrate including an insulation layer, and a radiation layer with a thermal conductivity, formed of conductive material and laminated on the insulation layer, a plurality of light-emitting elements mounted on the radiation layer, and a power supply wiring configured to electrically connect the light-emitting elements and to make the radiation layer electrically non-conductive.

WO 2015/091005 A1 discloses an optoelectronic semiconductor component which comprises a carrier. A number of active areas are provided on an upper side of the carrier, and are designed to generate radiation. At least three electrical contact sites are located on an underside of the carrier. The semiconductor component comprises at least one control unit for electrically addressing the semiconductor component, and for electrically controlling the active area. The active areas are provided in a regular grid, when viewed from above. Geometric centres of main radiation sides of the active areas are located on grid points of the grid, having a maximum tolerance of 20% of a grid spacing. In addition, a distance from the active areas, arranged peripherally in relation to the geometric centres, to a nearest edge of the carrier is a maximum of 60% of the grid spacing, when viewed from above.

US 2015/325598 A1 discloses a display device, comprising a layer stack, which comprises a semiconductor layer sequence having an active region for producing radiation and comprises a circuit layer. The semiconductor layer sequence forms a plurality of pixels. For each pixel, a respective switch connected in an electrically conductive manner to the pixel is formed in the circuit layer.

US 2011/026266 A1 discloses a light source module for a vehicle lamp, including an optical system that guides light emitted from the light source module in a certain irradiation direction and has an optical center, the light source module has a plurality of semiconductor light emitting elements disposed in a straight line and electrically connected to each other in series. One of the semiconductor light emitting elements that is positioned closest to the optical center of the optical system has a light emitting area that is smallest of the plurality of the semiconductor light emitting elements.

WO 2012/059837 A1 discloses a method for manufacturing a solid state light emitting device having a plurality of light-sources, the method comprising the steps of: providing a substrate having a growth surface; providing a mask layer on the growth surface, the mask layer having a plurality of openings through which the growth surface is exposed, wherein a largest lateral dimension of each of said openings is less than 0.3 µm and wherein the mask layer may comprise a first mask layer portion and a second mask layer portion, having the same surface area and comprising a plurality of openings wherein the first mask layer portion exhibits a first ratio between an exposed area of the growth surface and an unexposed area of the growth surface, and wherein the second mask layer portion exhibits a second ratio between an exposed area of the growth surface and an unexposed area of said growth surface, the second ratio being different from the first ratio; growing a base structure on the growth surface in each of the openings of the mask layer; and growing at least one light-generating quantum well layer on the surface of each of the base structures.

### SUMMARY OF INVENTION

As in the case of the light emitting apparatus disclosed in the aforementioned patent literatures, when the light emitting apparatus is formed by mounting a plurality of light emitting devices on one mounting substrate, a mounting error eventually occurs. A large distance needs to be secured between light emitting devices. In the light emitting apparatus disclosed in the aforementioned patent literatures, a wiring is formed at a position between light emitting devices where irradiation light from a light emitting device is shielded.

For example, when the light emitting apparatus is turned on, a dark region is formed between light emitting devices. Another problem is that, for example, due to a mounting error of a light emitting device, the distance between light emitting regions of the light emitting apparatus is not constant, and irradiation light is thereby not uniform.

Another problem is that when a defect exists in any one of many light emitting devices mounted on one mounting substrate in the light emitting apparatus disclosed in the aforementioned patent literatures, the light emitting apparatus as a whole becomes a defect product, and the manufacturing yield decreases.

The present invention has been made in view of the foregoing problems. An object of the present invention is to provide a light emitting apparatus with a high manufacturing yield that prevents leakage of light from one light emitting region to an adjacent light emitting region and reduces a dark region between light emitting regions.

A light emitting apparatus according to the present invention is provided as set forth in claim 1. Preferred embodiments of the present invention may be gathered from the dependent claims.

### BRIEF DESCRIPTION OF THE DRAWINGS

Fig. 1A is a top plan view of a light emitting apparatus according to a configuration comprising certain aspects of the present invention;
Fig. 1B is a cross-sectional view taken along a line 1B-1B of Fig. 1A;
Fig. 2A is a top plan view of a light emitting unit;
Fig. 2B is a cross-sectional view of the light emitting unit;
Fig. 3 is a diagram illustrating one example of a lighting unit using the light emitting apparatus;
Fig. 4A is a top plan view of a light emitting unit according to a modified illustrative example;
Fig. 4B is a cross-sectional view of the light emitting unit according to the modified illustrative example;
Fig. 5 is a cross-sectional view of a light emitting apparatus according to a modified example;
Fig. 6A is a top plan view of a light emitting unit according to a modified example according to the invention;
Fig. 6B is a top plan view of the light emitting unit according to the modified example according to the invention; and
Fig. 7 is a top plan view of a light emitting unit according to a modified illustrative example.

### DETAILED DESCRIPTION OF THE INVENTION

Preferred embodiments according to the present invention and illustrative examples will be described hereinbelow. These embodiments may be appropriately modified or combined. In the following description and accompanying drawings, for the sake of explanation, the same reference numeral is assigned to identical or substantially identical elements.

### [Embodiment]

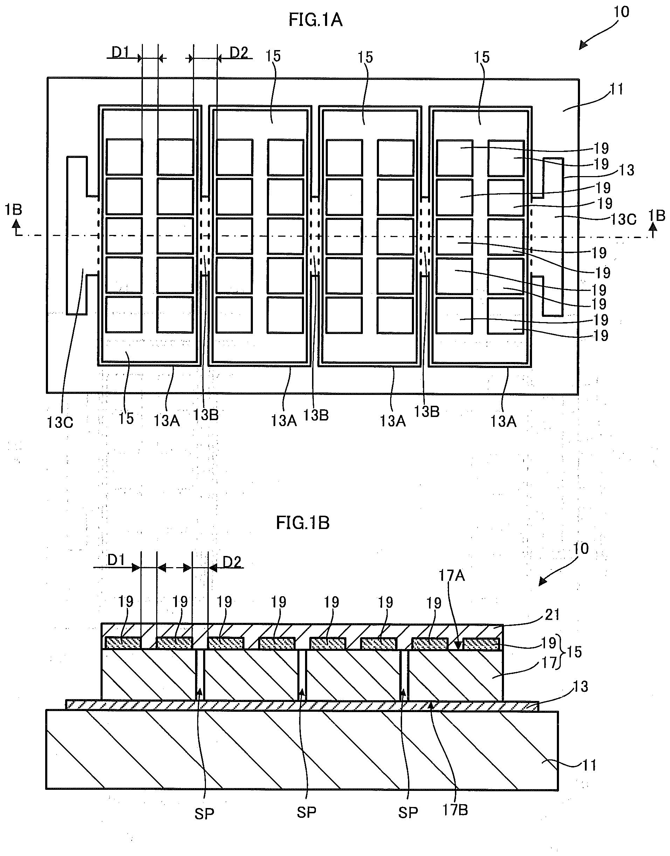

With reference to Figs. 1A and 1B, a light emitting apparatus 10 according to a configuration comprising certain aspects of the present invention will be described by way of an example of a light emitting apparatus using an LED device. A mounting substrate 11 is a rectangular planar substrate. The mounting substrate 11 includes a semiconductor, such as Si, a metal, such as Cu, or an insulating material, such as AlN or SiC.

A substrate bonding layer 13 acting as a bonding layer is a metal layer formed by laminating Ti, Pt, and Au in this order on the upper surface of the mounting substrate 11. The substrate bonding layer 13 has: a plurality of rectangular bonding regions 13A that are distanced from each other and arranged in a row on the mounting substrate 11; connection regions 13B connecting the plurality of rectangular bonding regions 13A; and a pad region 13C that extends over the outermost bonding regions 13A. The bonding region 13A has a longer side in a direction perpendicular to the alignment direction thereof. The dashed line in the figure indicates a boundary between the bonding region 13A, the connection region 13B, and the pad region 13C.

On each of the bonding regions 13A of the substrate bonding layer 13 of the mounting substrate 11, a light emitting unit 15 is disposed. The light emitting units 15 are arranged on the mounting substrate 11 in a row. The light emitting unit 15 has a support body 17 and a plurality of light emitting devices 19 containing a semiconductor structure layer (not shown) with a light emitting layer (not shown), each of the light emitting devices 19 being bonded to a top surface 17A of the support body 17. The illustrated example in the figure is configured such that four light emitting units 15 are arranged in a row. However, the number of the light emitting units 15 may be smaller than or equal to three, or greater than or equal to five. In addition, the light emitting units 15 may be arranged in two or more rows.

Each supporting body 17 of the light emitting unit 15 is formed from a conductive substrate of, for example, Si. The supporting body 17 with a square columnar shape has a rectangular top surface (upper surface) 17A and a rectangular bottom surface (lower surface) 17B. The adjacent supporting bodies 17 are disposed so as to be distanced from each other. Specifically, a space SP is formed between the adjacent supporting bodies 17.

A bottom electrode (not shown) is formed by laminating Ti, Pt, and Au in this order on the bottom surface 17B of the supporting body 17 so as to cover the bottom surface 17B. The bottom electrode is bonded to the substrate bonding layer 13 by means of thermo-compression, for example. A plurality of light emitting devices 19 containing a semiconductor structure layer (not shown) with a light emitting layer (not shown) are formed on the top surface 17A of the supporting body 17. According to this configuration, five light emitting devices 19 are aligned in each of two rows in the alignment direction parallel with the longitudinal direction of the upper surface of the supporting body 17. Specifically, the light emitting devices 19 are arranged in two rows in the direction perpendicular to the alignment direction of the light emitting units 15.

According to this configuration, to form the light emitting devices 19, a semiconductor layer containing a light emitting layer formed on a growth substrate (not shown) of, for example, sapphire is divided into a plurality of devices on the growth substrate, and after a plurality of the divided devices are attached to the supporting bodies 17, the growth substrate is removed. The light emitting unit 15 is a monolithic light emitting unit formed by integrating a plurality of the light emitting devices 19 and the supporting body 17. In other words, the light emitting unit 15 is of a thin film LED structure. On the supporting body 17, the light emitting devices 19 can be located very close to each other.

The film thickness of the light emitting device 19 thus formed, specifically, the thickness in the direction perpendicular to the upper surface of the supporting body 17, can be 10 µm or smaller. Light guided from one light emitting device 19 to the adjacent light emitting device 19 can thereby be decreased.

It is preferable that the distance between the locations where the light emitting devices 19 are arranged is as small as possible in the direction perpendicular to the alignment direction of the light emitting units 15 so as to reduce a dark region (dark line) formed between the light emitting devices 19. In the direction along the alignment direction of the light emitting units 15, it is preferable to set a distance D1 between the adjacent light emitting devices 19 within one light emitting unit 15 on the basis of a distance D2 between adjacent light emitting devices 19 in the adjacent respective light emitting units 15. It is more preferable to adjust the distance D1 so that the distances D1 and D2 are as equal as possible.

Due to, for example, the arrangement accuracy of the supporting body 17, it is difficult to arrange the adjacent light emitting devices 19 of the adjacent respective light emitting units 15 so that the distance therebetween is smaller than the distance between the adjacent light emitting devices 19 within one light emitting unit 15. In order for the distances D1 and D2 to be equal, the light emitting devices 19 are disposed on the supporting bodies 17 by setting the distance D2 equal to the distance D1. By adjusting the distance D2 according to the distance D1, occurrence of luminance unevenness within the light emitting apparatus 10 can be prevented.

It is a matter of course that the distance D2 between the adjacent light emitting devices 19 of the adjacent respective light emitting units 15 may be adjusted according to the distance D1 between the adjacent light emitting devices 19 within one light emitting unit 15. This adjustment can be made by setting the distance D1 in advance and, according to the distance D1, adjusting the distance between the locations where the light emitting units 15 are disposed.

A phosphor layer 21 is formed so that the light emitting portions 19 on the supporting body 17 are buried under the phosphor layer 21. Specifically, the phosphor layer 21 is continuously formed on the plurality of light emitting units 15 disposed on the mounting substrate 11 so as to entirely cover the plurality of light emitting units 15.

The phosphor layer 21 is, for example, a resin sheet containing phosphor particles and an amount of light scattering material. The phosphor particles used here are, for example, phosphor particles that are excited by blue light and emit yellow fluorescent light, such as Ce-activated yttrium-aluminum-garnet (YAG: Ce), Ce-activated terbium-aluminum-garnet (TAG: Ce), orthosilicate phosphor ((BaSrCa)SiO₄, etc.), or α-SiAlON phosphor ((Cα-α-SiAlON)SiO₄: Eu, etc.). The light scattering material is light scattering particles comprising, for example, TiO₂, SiO₂, ZnO, or Al₂O₃.

The phosphor layer 21 may be formed by coating the supporting body 17 with a liquid resin or glass binder containing a phosphor particle and a light scattering material and curing the coat on the supporting body 17 by means of, for example, thermosetting. The phosphor layer 21 may be formed of a plate containing a phosphor. Also, the phosphor layer 21 may be configured so that each light emitting device 19 is not buried under the phosphor layer 21 and the phosphor layer 21 is disposed above each light emitting device 19.

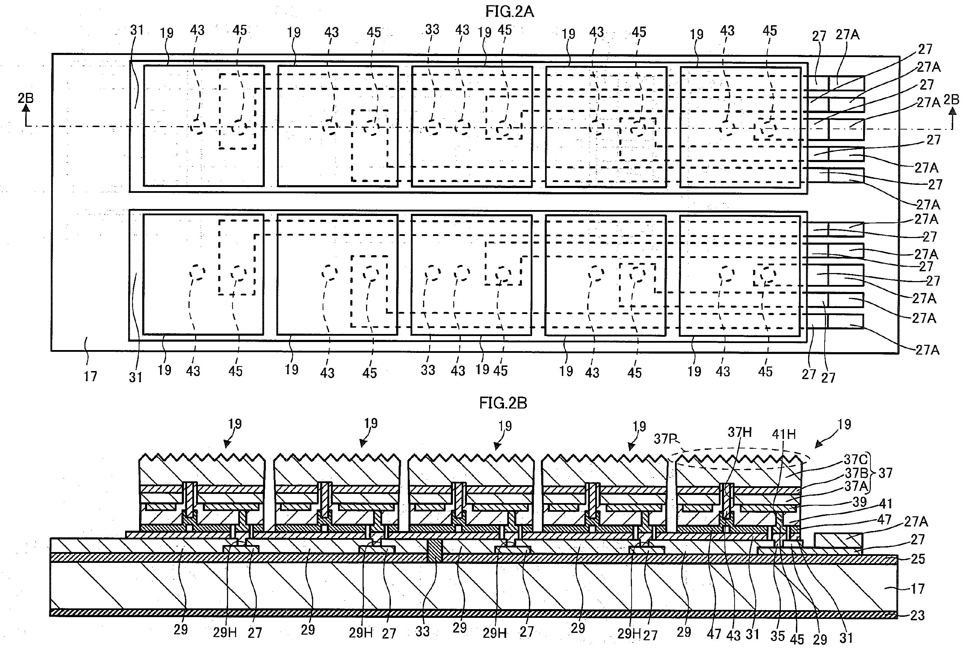

Fig. 2A is a top plan view of one light emitting unit 15. Fig. 2B is a cross-sectional view taken along a line 2B-2B of Fig. 2A. As described above, to form the light emitting unit 15, a semiconductor layer formed on a growth substrate (not shown) of, for example, sapphire is divided into a plurality of devices on the growth substrate, and after the plurality of divided devices are attached to the supporting bodies 17, the growth substrate is removed.

As illustrated in Figs. 2A and 2B, a bottom electrode 23 is formed on the surface of the supporting body 17 opposite to the surface on which the light emitting elements 19 are disposed, i.e., the bottom electrode 23 is formed on the lower surface of the supporting body 17. The bottom electrode 23 is formed by laminating Ti, Pt, and Au in this order on the surface of the supporting body 17. When a Si substrate is used as the supporting body 17, a thermal oxidation film on the lower surface of the supporting body 17 is grinded or removed by means of wet etching prior to formation of the bottom electrode 23.

To mount the light emitting unit 15 on the mounting substrate 11, for example, an AuSn paste is applied at the position on the substrate bonding layer 13 where the light emitting unit 15 is to be mounted, and in turn the light emitting unit 15 is mounted on the mounting substrate 11 so that the bottom electrode 23 is placed on the AuSn paste. Thereafter, the substrate bonding layer 13 and the bottom electrode 23 are bonded by means of heating.

On the upper surface of the supporting body 17, an upper surface insulating layer 25 serving as a first insulating layer formed from an insulating material, such as SiO₂, is formed. When the supporting body 17 is a Si substrate, the upper surface insulating layer 25 may be a heat oxidation film formed on the surface of the Si substrate.

On the upper surface insulating layer 25, a plurality of individual wirings 27 that are formed from a conductor, such as Au, are formed to be distanced from each other. Each of the plurality of individual wirings 27 extends from one end of the upper surface of the supporting body 17 in the longitudinal direction to the region directly below each light emitting device 19.

The plurality of individual wirings 27 each have one end exposed at one end of the upper surface of the supporting body 17 in the longitudinal direction and the other end under the light emitting device 19. At the exposed end of each of the plurality of individual wirings 27, there is provided an individual wiring pad 27A that is formed from a conductor, such as Au, and can be electrically connected to an external element by means of, for example, wiring bonding.

On the upper surface insulating layer 25 and the individual wiring 27, an interlayer insulating layer 29 serving as a second insulating layer formed from an insulating material, such as SiO₂, is formed. In the region directly below each light emitting device 19, an opening 29H is formed in the interlayer insulating layer 29. A part of the upper surface of the individual wiring 27 is exposed through the opening 29H. The interlayer insulating layer 29 is not formed on the individual wiring pad 27A. Specifically, the interlayer insulating layer 29 is formed so as to cover the individual wiring 27 on the upper insulating layer 25 while the individual wiring pad 27A is exposed and the upper surface of the individual wiring 27 is partially exposed in the region directly below the light emitting device 19.

On the interlayer insulating layer 29, a layered common wiring 31 that is formed from a conductor, such as Au, and is commonly and electrically connected to each light emitting device 19 is formed. The common wiring 31 is formed so as to circumvent the opening 29H. Specifically, the opening 29H and a surrounding region thereof are exposed from the common wiring 31.

A through wiring 33 is formed from a conductor, such as Au, so as to be in contact with the surface of the supporting body 17 in the region below any one of the light emitting devices 19 (the light emitting device in the center in the figures). Also, the through wiring 33 is formed so as to penetrate through the upper surface insulating layer 25 and the interlayer insulating layer 29 and reach the upper surface of the interlayer insulating layer 29. The through wiring 33 is in contact with the supporting body 17 and the common wiring 31 and electrically connects the supporting body 17 to the common wiring 31. Two or more through wirings 33 may be formed, and the through wiring 33 may be formed in a region under two or more light emitting devices 19.

Above the upper surface of the individual wiring 27 exposed through the opening 29H, an individual electrode 35 formed from a conductor, such as Au, is formed. Each individual electrode 35 is, for example, formed so as to be distanced from the common wiring 31 and thereby electrically insulated from the common wiring 31.

The light emitting device 19 is bonded to the common wiring 31 and the individual electrode 35 and formed above the supporting body 17. The light emitting device 19 has a semiconductor structure layer 37 formed by laminating a p-type semiconductor layer 37A, a light emitting layer 37B, and an n-type semiconductor layer 37C in this order on the supporting body 17. The semiconductor structure layer 37 has the composition of, for example, AlₓIn_{y}Ga_{1-x-y}N (0 ≤ x ≤ 1, 0 ≤ y ≤ 1).

In the semiconductor structure layer 37, a through hole 37H is formed. The through hole 37H originates from the surface of the semiconductor structure layer 37 close to the supporting body 17, i.e., from the surface of the p-type semiconductor layer 37A, and penetrates through the p-type semiconductor layer 37A and the light emitting layer 37B to reach an inner portion of the n-type semiconductor layer 37C. The figure illustrates that only one through hole 37H penetrating through each light emitting device 19, but in fact a plurality of the through holes 37H are formed.

On the surface of the n-type semiconductor layer 37C, a conical protrusion 37P (the structure surrounded by the dashed line in the figure) is formed. Through the surface of the n-type semiconductor layer 37C, the conical protrusion 37P is directed to efficiently releasing light emitted from the light emitting layer 37B to the outside. The conical protrusion 37P may be formed by immersing the surface of the n-type semiconductor layer 37C in an alkali solution, for example, a TMAH solution, to build an uneven or protrusion/depression structure derived from a semiconductor crystal structure on the surface of the n-type semiconductor layer 37C. The conical protrusion 37P does not necessarily need to be formed.

A p-contact electrode 39 is formed by, for example, laminating Ag and TiW in this order on the surface of the p-type semiconductor layer 37A. The p-contact electrode 39 is not formed on the peripheral edge region of the through hole 37H on the surface of the p-type semiconductor layer 37A and the edge region on the surface of the p-type semiconductor layer 37A. Specifically, the peripheral edge region of the through hole 37H and the edge region on the surface of the p-type semiconductor layer 37A are exposed from the p-contact electrode 39.

An insulating layer 41 is formed so as to cover the semiconductor layer 37A, the p-contact electrode 39, and the side surface of the through hole 37H. At the bottom of the through hole 37H, the n-type semiconductor layer 37C is exposed from the insulating layer 41. In the insulating layer 41, a through hole 41H that extends from the surface of the insulating layer 41 to the p-contact electrode 39 is formed. Specifically, a part of the p-contact electrode 39 is exposed from the insulating layer 41 through the through hole 41H.

An n-contact electrode 43 is formed in the through hole 37H. The n-contact electrode 43 is formed from a metal material and is in contact with the surface of the n-type semiconductor layer 37C exposed from the insulating layer 41. The n-contact electrode 43 is, for example, formed so as to protrude from the surface of the insulating layer 41.

A p-electrode 45 is formed in the through hole 41H. The p-electrode 45 is in contact with the surface of the p-contact electrode 39 exposed from the insulating layer 41. The p-electrode 45 is formed by laminating Ti, Pt, and Au in this order on the surface of the p-contact electrode 39. The p-electrode 45 is formed so as to protrude from the insulating layer 41.

An n-electrode 47 is formed on the surface of the insulating layer 41. The n-electrode 47 is formed by laminating Ti, Pt, and Au in this order on the surface of the insulating layer 41. The n-electrode 47 is formed so as to be distanced from the p-electrode 45.

The p-electrode 45 and the n-electrode 47 are bonded to the individual electrode 35 and the common electrode 31, respectively, formed on the supporting body 17, by means of, for example, heat bonding in a vacuum environment. Specifically, the individual electrode 35 and the p-electrode 45 are electrically connected to each other, and the common wiring 31 and the n-electrode 47 are electrically connected to each other. Accordingly, the light emitting devices 19 are electrically connected in parallel between the pad portion 13A of the substrate bonding layer 13 and the individual wiring pad 27A. The light emitting devices 19 can be individually driven by turning on and off the power of each individual wiring pad 27A.

As described above, to form the light emitting apparatus 10, the light emitting devices 19 are formed on the growth substrate and after the light emitting devices 19 are attached on the supporting body 17. The light emitting devices 19 can be formed on the supporting body 17 so that the distance therebetween is very small within the light emitting unit 15. Occurrence of a dark region (dark line) formed between the adjacent light emitting devices 19 can thereby be reduced.

One light emitting apparatus 10 according to the aforementioned configuration is formed by arranging a plurality of the light emitting units 15 including the supporting bodies, on each of which a plurality of the light emitting devices 19 are formed. One light emitting apparatus 10 according to the aforementioned configuration is not formed of one light emitting unit 15 having a required number of light emitting devices. Instead, a light emitting apparatus having a required number of light emitting devices is formed by arranging a plurality of the separate light emitting units 15.

When one light emitting apparatus is formed of one light emitting unit and the light emitting unit is partially defected, the light emitting unit having a number of light emitting devices required for the light emitting apparatus needs to be entirely replaced. Conversely, as in the case of the light emitting apparatus 10 formed by arranging a plurality of the light emitting units 15, when the light emitting unit 15 is defected, only the defected unit needs to be replaced. The yield of the light emitting apparatus 10 can thus be enhanced.

In the light emitting apparatus 10 according to the aforementioned configuration, a space SP (see Fig. 1) is formed between the adjacent supporting bodies 17 of the adjacent light emitting units 15. Light that is emitted from the light emitting device 19 of one light emitting unit 15, propagates thorough the phosphor layer 21, and is destined to another light emitting unit 15 adjacent the aforementioned one light emitting unit 15 is attenuated after entering the space SP between the adjacent supporting bodies 17. Most of such light does not exit from the space SP.

Accordingly, light emitted from the light emitting device 19 of one light emitting unit 15 can be prevented from propagating through the phosphor layer 21 and leaking to the adjacent light emitting unit 15. In particular, when the light emitting devices 19 for using the light emitting apparatus 10 for, for example, an adaptive driving beam (ADB: orientation variable head lamp) are separately driven, it is possible to reduce leakage of light to the adjacent light emitting device 15, in other words, crosstalk of light.

In the present invention, the film thickness of the light emitting device 19 can be 10 µm or smaller. The amount of light emitted from the sidewall of the light emitting device 19 can be reduced, and crosstalk to an adjacent device can be further reduced.

As described above, the light emitting apparatus 10 having a required number of the light emitting devices 19 is formed by arranging a plurality of the light emitting units 15 separate from each other. The light emitting devices 19, the number of which is required for the light emitting apparatus 10, are distributed on a plurality of the supporting bodies 17 distanced from each other. Instead of disposing, on one supporting body, all light emitting devices required for the light emitting apparatus, the plane area of each supporting body is made smaller. A defect, such as a crack occurring to a supporting body due to difference in the coefficient of thermal expansion between the supporting body and a mounting substrate, can be prevented.

As illustrated above, in the light emitting apparatus 10, the light emitting devices 19 can be arranged very close to each other in the direction perpendicular to the alignment direction of the light emitting units 15. A dark region (dark line) is rarely formed due to the space between the light emitting devices 19 in the direction perpendicular to the alignment direction of the light emitting units.

When a dark region (dark line) of irradiation light is reduced by an optical system, such as a lens, arranged in the irradiation direction of the light emitting apparatus 10, the optical system needs to address only a dark region (dark line) formed along the alignment direction of the light emitting units 15. The structure of an optical system disposed on the light emitting apparatus 10 can thus be simplified.

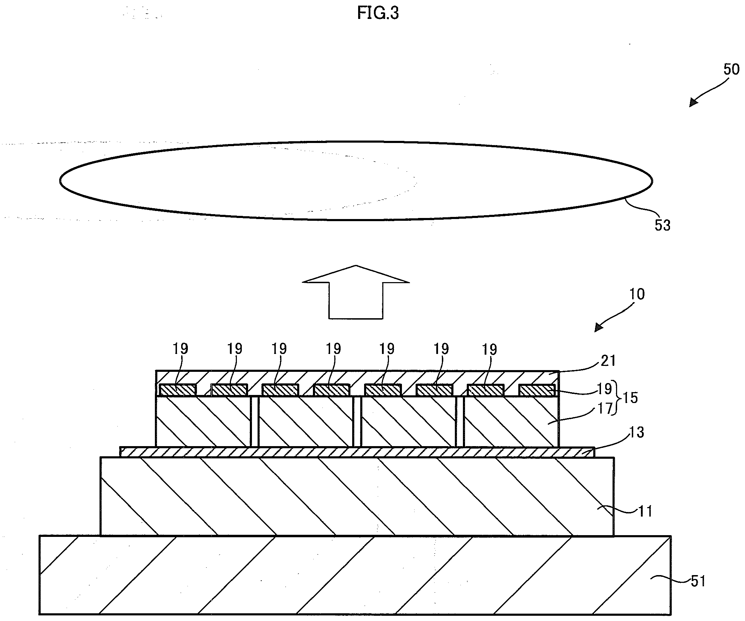

Fig. 3 illustrates a lighting unit 50 as one example of a lighting fixture using the light emitting apparatus 10. In the lighting unit 50, the mounting substrate 11 is bonded to the surface of a metal substrate 51 to fix the light emitting apparatus 10 to the metal substrate 51. In the light emitting direction (indicated by the white allow in the figure) of the light emitting apparatus 10, a lens 53 is disposed at a location opposite to the upper surface of the phosphor layer 21. A structure for enhancing heat dissipation, such as a heat dissipation fin, may be provided on the metal substrate 51 or attached as a separate body to the metal substrate 51.

As described above, when a dark region (dark line) of irradiation light from the light emitting apparatus 10 is tried to be reduced, only a dark region (dark line) formed along the alignment direction of the light emitting units 15 needs to be addressed. Thus, the lens 53 should be formed with a repetitive structure in which a plurality of cylindrical lenses are arranged so that images formed by light emitted from, for example, light emitting devices are overlapped with each other only in the alignment direction of the light emitting units 15.

A structure for reducing a dark region (dark line) does not necessarily have to be provided in the direction perpendicular to the alignment direction of the light emitting units 15. Employment of the light emitting apparatus 10 enables use of a lens of a simple structure as the lens 53.

### [Modified Illustrative Example 1]

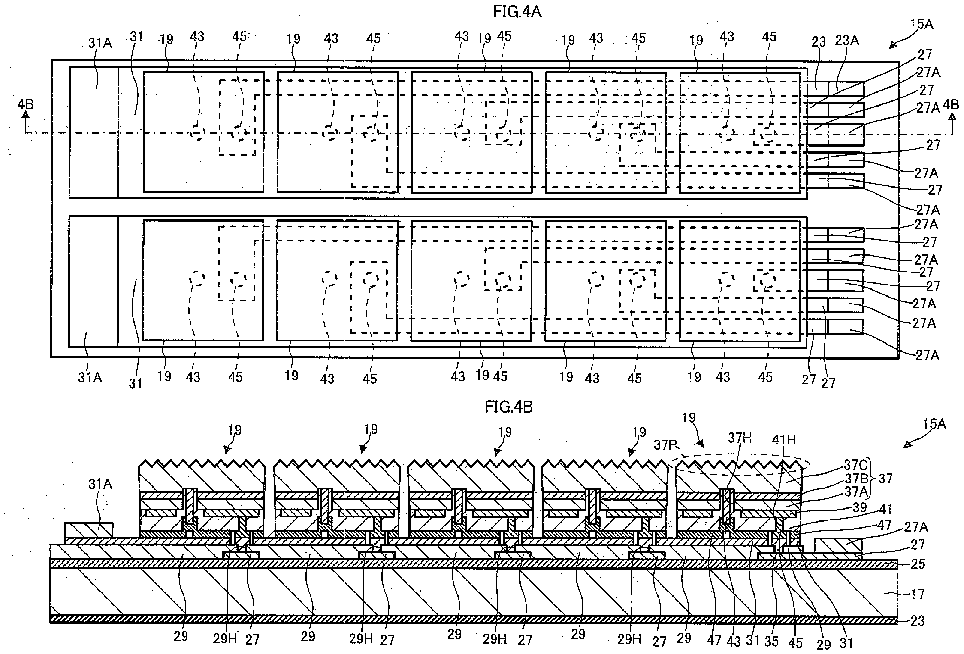

A description will now be given of an example where the bottom electrode 23 is not used to supply power to the light emitting device 19 of the light emitting apparatus 10. Fig. 4A is a top plan view of a light emitting unit 15A of the light emitting apparatus 10 according to the modified illustrative example 1. Fig. 4B is a cross-sectional view taken along a line 4B-4B of Fig. 4A.

The light emitting unit 15A of the light emitting apparatus according to the modified illustrative example 1 is different from the light emitting unit 15 according to the aforementioned embodiment in terms of the configuration of the common wiring 31. Another difference therebetween is that the through wiring 33 is not disposed in the light emitting unit 15A according to the modified illustrative example. The light emitting unit 15 according to the aforementioned embodiment and the light emitting unit 15A of the according to the modified illustrative example are identical in terms of the other features.

A common wiring pad 31A is disposed at the end portion of the common wiring 31 of the light emitting unit 15A according to the modified illustrative example 1. The aforementioned end portion of the common wiring 31 is opposite to the end portion where the individual wiring pad 27A is formed on the supporting body 17. The common wiring pad 31A is formed from a conductor, for example, Au and can be electrically connected to an external element by means of, for example, wire bonding. Specifically, in the light emitting unit 15A according to the modified illustrative example 1, the light emitting devices 19 are electrically connected in parallel between the individual wiring pad 27A and the common wiring pad 31A.

In the light emitting unit 15A according to the modified illustrative example 1, the bottom electrode 23 simply acts as a bonding layer with the bonding region 13A (see Fig. 1A). In the light emitting apparatus 10 that uses the light emitting unit 15A according to the modified illustrative example 1, only the bonding region 13A needs to exist in the substrate bonding layer 13, and the connection region 13B and the pad region 13C do not need to be formed.

In the light emitting apparatus 10 that uses the light emitting unit 15A according to the modified example 1, power supply via the supporting body 17 is not necessary, and the supporting body 17 does not need to be a conductive substrate. The supporting body 17 may be an insulating substrate. When the supporting body 17 is formed from an insulating substrate, the upper surface insulating layer 25 does not need to be formed.

### [Modified Illustrative Example 2]

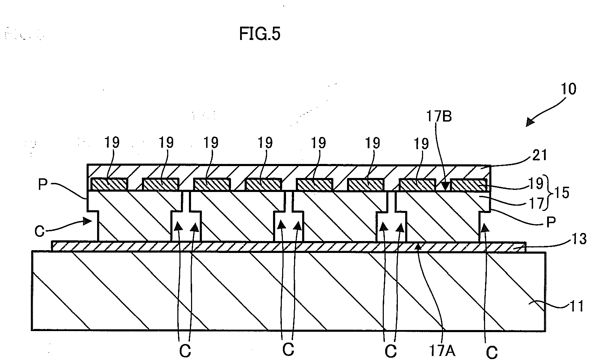

A description will now be given of an example which is different from the aforementioned embodiments in terms of the shape of the supporting body 17. Fig. 5 is a cross-sectional view of the light emitting apparatus 10 according to the modified example 2. As illustrated in Fig. 5, a notched recess portion C, which is notched from the side of the bottom surface 17B, is provided on the side surfaces of the supporting body 17. The width of the bottom surface 17B of the supporting body 17 is smaller than the width of the top surface 17A thereof. The supporting body 17 has an eave-shaped protrusion P that protrudes outwardly at the top portion in a direction parallel with the top surface 17A.

In other words, in an area closer to the top surface 17A, the supporting body 17 has the protrusion P on the side surface along each adjacent region between the light emitting units 15.

The distance between the side surfaces of the supporting bodies 17 of the adjacent light emitting units 15 is greater in the area near the top surface 17A where the protrusion P is formed than the distance in the area where the protrusion P is not formed. In other words, the space between the adjacent supporting bodies 17 that is below the area where the protrusion P is formed is wider than the space between the protrusions P of the adjacent supporting bodies 17. This space defined by the protrusions P and the notched recess portions C functions as an escape of a flux eluted from a metal paste, such as AuSn, containing a flux used for bonding the light emitting unit 15 and the mounting substrate 11.

Specifically, in manufacturing the light emitting apparatus 10 according to the modified illustrative example 2, the space defined by the protrusions P and the notched recess portions C functions as an escape of a flux at the time of bonding the light emitting unit 15 and the mounting substrate 11, and the space between the supporting bodies 17 is not completely filled with the flux. The stress acting on the side surface of the supporting bodies 17 by the eluted flux at the time of bonding is reduced. The light emitting unit 15 can be prevented from inclining or deviating from the positon where the light emitting unit 15 is to be mounted during fusion bonding.

### [Example of LED Arrangement]

The above-described embodiments have been described with reference to the drawings with regard to the configuration of one light emitting unit 15 where five light emitting devices 19 of an identical size are arranged in each of two rows on the supporting bodies 17. However, the light emitting devices 19 may be arranged differently. For example, the light emitting devices 19 may be arranged in one or three or more rows in the direction perpendicular to the arrangement direction of the light emitting units 15. In addition, the light emitting devices 19 may have different sizes. In particular, according to the invention, the light emitting devices 19 have different lengths in the direction perpendicular to the arrangement direction of the light emitting units 15.

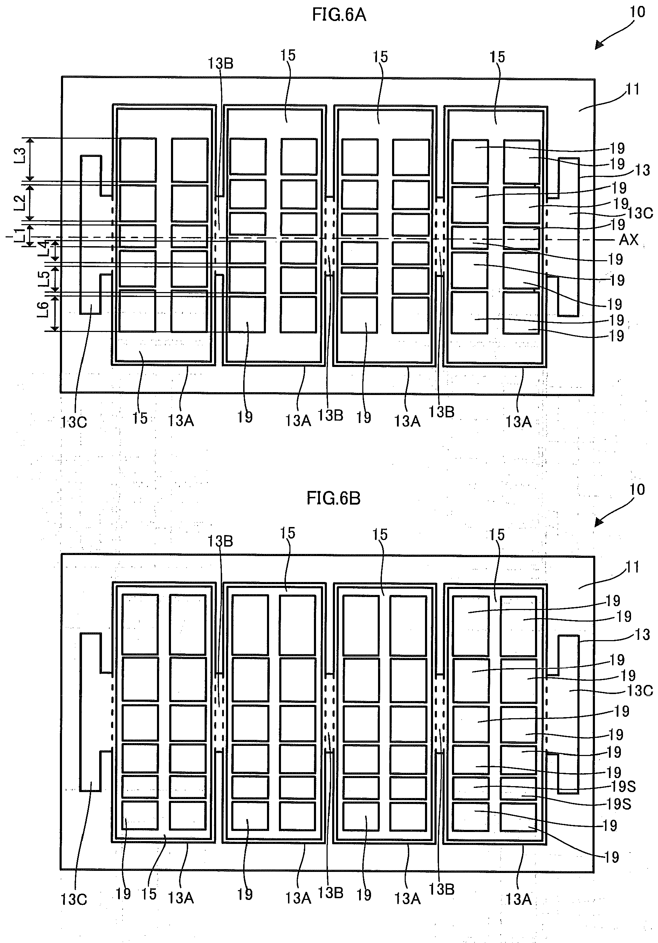

Fig. 6A illustrates a modified example according to the invention of arrangement of the light emitting device 19. For example, when the light emitting apparatus 10 is used as a light source of ADB, the light emitting region eventually needs to be finely changed at the central portion of the light emitting apparatus 10. In such a case, for example, the lengths of the light emitting devices 19 in the direction perpendicular to the alignment direction of the light emitting units 15 may be set to decrease with a decrease in the distance of the light emitting device 19 to a center axis AX, which runs along the alignment direction of the light emitting units 15. As illustrated in Fig. 6A, when the widths of the light emitting devices 19 are denoted by L1, L2, and L3 in the ascending order of the distance of the light emitting device 19 from the center axis AX, i.e., in the ascending order of the distance from the center position in the direction perpendicular to the alignment direction of the light emitting units, the widths of the light emitting devices 19 may be set so that L1 < L2 < L3 holds true.

Also, the number of the light emitting devices 19 may be changed for each light emitting unit 15. In Fig. 6A, the number of the light emitting devices 19 mounted on the light emitting unit 15 is set to increase with a decrease in the distance of the light emitting unit 15 to the center position of the light emitting apparatus 10. It may be possible to configure so that the number of the light emitting devices 19 increases as the distance to the center position decreases and that turning on and off is controlled for each smaller region. In this case as well, if necessary, the widths (lengths) of the light emitting devices may be set to decrease as the distance to a center axis C decreases. For example, when the widths of the light emitting devices 19 are denoted by L4, L5, and L6 in the ascending order of the distance of the light emitting device 19 from the center axis AX, the widths of the light emitting devices 19 may be set so that L4 < L5 < L6 holds true.

As illustrated in Fig. 6B, a smallest light emitting device 19S may be disposed at a location distanced from the center positon of the light emitting apparatus 10. The sizes (lengths) of the light emitting devices 19 other than the smallest light emitting device 19S increase with an increase in the distance from the smallest light emitting device 19S. For example, the sizes of the other light emitting devices 19 may be set to constantly increase as the distance from the smallest light emitting device 19S increases. The used light emitting units 15 are all the same.

When the lighting unit 50 is formed of the aforementioned light emitting apparatus, the axis to be aligned with the optical axis of the lens is located at a position closer to the smallest light emitting device 19S than to the center position of the light emitting unit 15.

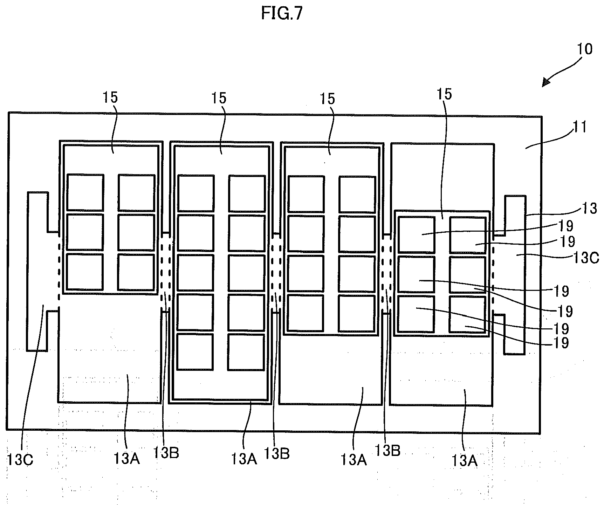

As illustrated in Fig. 7, the light emitting units 15 with different sizes may be arranged. In this case, as illustrated in Fig. 7, the light emitting units 15 may be offset from each other in the alignment direction of the light emitting units 15.

In the above-described configurations, illustrative examples and embodiments, examples of individually driving the light emitting devices 19 have been described. However, by appropriately changing a wiring, the light emitting devices 19 may be driven individually or entirely by the driving method or may be controlled so that the light emitting devices 19 in a certain group are driven together.

In the above-described configurations, illustrative examples and embodiments, examples where the light emitting device 19 is an LED device have been described. However, the light emitting device 19 may be another type of light emitting device, such as a vertical resonator-type light emitting diode.

In the above-described configurations, illustrative examples and embodiments, examples where the phosphor layer 21 is continuously formed over all the light emitting units 15 have been described. However, the configuration of the phosphor layer 21 is not limited to configurations, illustrative examples and embodiments. For example, the phosphor layer 21 may be formed on each light emitting device, each row of light emitting devices in a light emitting unit, or each light emitting unit so that the phosphor layer 21 is separately formed. In this case, light shielding may be performed by filling a white resin, a black resin, or the like in each gap between the phosphor layers 21 thus formed. In this manner, the phosphor layer 21 is spread so as to reduce leakage of light from one light emitting device 19 to the region of the adjacent light emitting device 19, specifically, crosstalk of light.

Various numerical values, dimensions, materials, etc. as well as, for example, the configuration of a semiconductor structure layer or metal layer according to the configurations, illustrative examples and embodiments are merely for illustrative purposes. Different ones may be appropriately selected depending on, for example, the application and a semiconductor device to be manufactured. The invention is defined by the appended claims.

## Claims

1. A light emitting apparatus (10) comprising:
a mounting substrate (11);
a plurality of supporting bodies (17) disposed on the mounting substrate (11) and linearly aligned in an alignment direction; and
a plurality of light emitting devices (19) disposed on upper surfaces (17A) of the plurality of supporting bodies (17),
wherein the plurality of light emitting devices (19) are arranged on each of the plurality of supporting bodies (19) in a plurality of rows in a direction perpendicular to the alignment direction of the plurality of supporting bodies (17), wherein
the plurality of light emitting devices (19) are disposed in the alignment direction on one of the supporting bodies (17) in a plurality of rows, and the adjacent light emitting devices (19) in one of the supporting bodies (17) are arranged in the alignment direction so that a distance (D1) therebetween is substantially equal to a distance (D2) between adjacent ones of the light emitting devices (19) of the adjacent respective supporting bodies (17), **characterized in that**
the plurality of light emitting devices (19) have different lengths in the direction perpendicular to the alignment direction of the plurality of supporting bodies (17).

2. The light emitting apparatus according to claim 1, wherein
a length of the plurality of light emitting devices (19) monotonically increases in the direction perpendicular to the alignment direction of the plurality of supporting bodies (17) with an increase in a distance in the perpendicular direction to a light emitting device (19) whose length is smallest in the perpendicular direction.

3. The light emitting apparatus according to claim 2, wherein
the plurality of light emitting devices (19) on one of the supporting bodies (17) are electrically connected with each other in parallel.

4. The light emitting apparatus according to claim 3, wherein
a film thickness of the plurality of light emitting devices (19) is 10 µm or smaller.

5. The light emitting apparatus according to claim 4, further comprising:
a phosphor layer (21) continuously formed on all of the plurality of light emitting devices (19) on at least one of the supporting bodies (17).

6. The light emitting apparatus according to anyone of claims 1 to 5, wherein said supporting bodies (17) have a notched recess portion (C) provided on the side surfaces of said supporting body (17) and notched from the side of the bottom surface (17B) of said supporting body (17).

7. The light emitting apparatus according to anyone of claims 1 to 6, wherein a space (SP) is formed between the adjacent supporting bodies (17).

## Patentansprüche

1. Lichtemissionsvorrichtung (10), die Folgendes aufweist:
ein Befestigungssubstrat (11);
eine Vielzahl von Tragkörpern (17), die auf dem Befestigungssubstrat (11) angeordnet sind, und linear in einer Ausrichtungsrichtung ausgerichtet sind; und
eine Vielzahl von Lichtemissionseinrichtungen (19), die auf Oberseiten (17A) der Vielzahl von Tragkörpern (17) angeordnet sind,
wobei die Vielzahl von Lichtemissionseinrichtungen (19) auf jedem der Vielzahl von Tragkörpern (19) in einer Vielzahl von Zeilen in einer Richtung senkrecht zur Ausrichtungsrichtung der Vielzahl von Tragkörpern (17) angeordnet ist,
wobei die Vielzahl von Lichtemissionseinrichtungen (19) in der Ausrichtungsrichtung auf einem der Tragkörper (17) in einer Vielzahl von Zeilen angeordnet ist bzw. sind, und wobei die benachbarten Lichtemissionseinrichtungen (19) in einem der Tragkörper (17) in der Ausrichtungsrichtung so angeordnet sind, dass eine Distanz (D1) dazwischen im Wesentlichen gleich einer Distanz (D2) zwischen benachbarten Lichtemissionseinrichtungen (19) der jeweiligen benachbarten Tragkörper (17) ist,
**dadurch gekennzeichnet, dass**
die Vielzahl von Lichtemissionseinrichtungen (19) in der Richtung senkrecht zur Ausrichtungsrichtung der Vielzahl von Tragkörpern (17) unterschiedliche Längen haben.

2. Lichtemissionsvorrichtung gemäß Anspruch 1, wobei eine Länge der Vielzahl von Lichtemissionseinrichtungen (19) in der Richtung senkrecht zur Ausrichtungsrichtung der Vielzahl von Tragkörpern (17) monoton zunimmt, und zwar mit einer Zunahme einer Distanz in der senkrechten Richtung zu einer Lichtemissionseinrichtung (19), deren Länge in der senkrechten Richtung am kleinsten ist.

3. Lichtemissionsvorrichtung gemäß Anspruch 2, wobei die Vielzahl von Lichtemissionseinrichtungen (19) auf einem der Tragkörper (17) elektrisch miteinander parallel verbunden ist.

4. Lichtemissionsvorrichtung gemäß Anspruch 3, wobei eine Filmdicke der Vielzahl von Lichtemissionseinrichtungen (19) 10 µm oder kleiner ist.

5. Lichtemissionsvorrichtung gemäß Anspruch 4, die weiter Folgendes aufweist:
eine Leuchtstoffschicht (21), die kontinuierlich auf allen der Vielzahl von Lichtemissionseinrichtungen (19) auf zumindest einem der Tragkörper (17) geformt ist.

6. Lichtemissionseinrichtung nach einem der Ansprüche 1 bis 5, wobei die Tragkörper (17) einen eingeschnittenen Ausnehmungsteil (C) haben, der an den Seitenflächen des Tragkörpers (17) vorgesehen ist und von der Seite der Unterseite (17B) des Tragkörpers (17) eingeschnitten ist.

7. Lichtemissionsvorrichtung nach einem der Ansprüche 1 bis 6, wobei ein Raum (SP) zwischen den benachbarten Tragkörpern (17) geformt ist.

## Revendications

1. Appareil émettant de la lumière (10) comprenant :
un substrat de montage (11) ;
une pluralité de corps de support (17) disposés sur le substrat de montage (11) et alignés linéairement selon une direction d'alignement ; et
une pluralité de dispositifs émettant de la lumière (19) disposés sur les surfaces supérieures (17A) de la pluralité de corps de support (17),
dans lequel la pluralité de dispositifs émettant de la lumière (19) sont agencés sur chaque corps de la pluralité de corps de support (17) selon une pluralité de rangées dans une direction perpendiculaire à la direction d'alignement de la pluralité de corps de support (17), dans lequel
la pluralité de dispositifs émettant de la lumière (19) sont disposés selon la direction d'alignement sur un des corps de support (17) sur une pluralité de rangées, et les dispositifs émettant de la lumière adjacents (19) dans un des corps de support (17) sont agencés selon la direction d'alignement de sorte qu'une distance (D1) entre eux soit sensiblement égale à une distance (D2) entre des dispositifs adjacents parmi les dispositifs émettant de la lumière (19) des corps de support respectifs adjacents (17), **caractérisé en ce que**
la pluralité de dispositifs émettant de la lumière (19) ont des longueurs différentes dans la direction perpendiculaire à la direction d'alignement de la pluralité de corps de support (17) .

2. Appareil émettant de la lumière selon la revendication 1, dans lequel
une longueur de la pluralité de dispositifs émettant de la lumière (19) augmente de façon monotone dans la direction perpendiculaire à la direction d'alignement de la pluralité de corps de support (17) avec une augmentation de distance dans la direction perpendiculaire à un dispositif émettant de la lumière (19) dont la longueur est la plus petite dans la direction perpendiculaire.

3. Appareil émettant de la lumière selon la revendication 2, dans lequel
la pluralité de dispositifs émettant de la lumière (19) sur un des corps de support (17) sont connectés électriquement les uns aux autres en parallèle.

4. Appareil émettant de la lumière selon la revendication 3, dans lequel
une épaisseur de film de la pluralité de dispositifs émettant de la lumière (19) est 10 µm ou moins.

5. Appareil émettant de la lumière selon la revendication 4, comprenant en outre :
une couche de phosphore (21) formée de façon continue sur toute la pluralité de dispositifs émettant de la lumière (19) sur au moins un des corps de support (17).

6. Appareil émettant de la lumière selon l'une quelconque des revendications 1 à 5, dans lequel lesdits corps de support (17) ont une partie creusée d'une encoche (C) prévue sur les surfaces latérales dudit corps de support (17) et l'encoche s'étendant à partir du côté de la surface inférieure (17B) dudit corps de support (17).

7. Appareil émettant de la lumière selon l'une quelconque des revendications 1 à 6, dans lequel un intervalle (SP) est formé entre les corps de support adjacents (17).
